# EUROPÄISCHE PATENTANMELDUNG

(11) **EP 0 892 593 A2**
(43) Veröffentlichungstag der Anmeldung: **20.01.1999**
(21) Anmeldenummer: 98112331.8
(22) Anmeldetag: 03.07.1998
(51) Int. Cl.: H05K 9/00

(54) **Befestigungsmittel für Abschirmgehäuse von elektrischen Leiterplatten und Verfahren zu seiner Herstellung**

(30) Priorität: 16.07.1997 DE 19730417
(71) Anmelder: HAGENUK GMBH, D-24118 Kiel (DE)
(72) Erfinder: Schaefer, Jürgen, 24149 Kiel (DE); Scheler, Holger, 24147 Klausdorf (DE); Hinrichs, Jochen, 24109 Kiel (DE); Krügel, Oskar, 24161 Kiel/Altenholz (DE)
(74) Vertreter: Hansmann, Dierk, Dipl.-Ing.

(57) **Zusammenfassung**

Es wird ein Befestigungsmittel für Abschirmgehäuse von elektrischen Leiterplatten beschrieben, das sich dadurch auszeichnet, daß es ein Klemmprofil aus elektrisch leitendem Material zum Einklemmen einer Abschirmgehäusewand umfaßt, das mindestens einen Zentrierzapfen zum Befestigen des Befestigungsmittels in einer Bohrung der Leiterplatte aufweist.

## Beschreibung

Die Erfindung betrifft ein Befestigungsmittel für Abschirmgehäuse von elektrischen Leiterplatten, gebildet durch ein Klemmprofil aus einem elektrisch leitenden Material zum Einklemmen einer Abschirmgehäusewand.

Elektronikbaugruppen, in denen hochfrequente Spannungen erzeugt und verarbeitet werden, müssen im allgemeinen mit einem Abschirmgehäuse umgeben werden, um die Abstrahlung hochfreguenter elektromagnetischer Strahlung auf benachbarte Elektronikbaugruppen auf zulässige Werte zu begrenzen. Das Abschirmgehäuse besteht aus Metall oder metallisiertem Kunststoff und muß mit einem möglichst geringen Übergangswiderstand mit dem Massepotential der Schaltung verbunden sein. Die Schaltung bzw. Elektronikbaugruppe ist dabei häufig als Flachbaugruppe mit einem Schaltungsträger in Form einer elektrischen Leiterplatte ausgebildet. Zur sicheren Befestigung des Abschirmgehäuses an der Leiterplatte sind verschiedene Vorschläge gemacht worden, wobei besonderes Augenmerk auf eine gute elektrische Verbindung zwischen Abschirmgehäuse und dem Masseanschluß der Schaltung gelegt werden muß.

Eine solche Verbindung kann beispielsweise durch eine mechanische Vorspannung des Gehäuses verbessert werden, das aus einem elastisch verformbaren Elastomer mit einem hohen Anteil fein verteilter, elektrisch leitender Partikel besteht. Hierbei sind allerdings auch elektrisch leitende Dichtungen erforderlich, die große Querschnitte haben, da der Deformationsgrad des Elastomers durch die leitenden Partikel eingeschränkt ist. Ferner muß das Abschirmgehäuse im Bereich der Dichtung eine hohe Wandstärke aufweisen. Ein weiterer Nachteil besteht darin, daß die Kosten für das Material der Dichtung sowie für deren Herstellung relativ hoch sind.

Eine mechanische und elektrisch leitende Verbindung des Abschirmgehäuses mit der Leiterplatte kann auch durch kalthärtende Klebstoffe mit einem hohen Volumenanteil an leitenden Partikeln realisiert werden. Die Herstellung und Verarbeitung eines solchen Leitklebers ist allerdings sehr teuer. Ferner ist eine eventuelle Reparatur der Hochfreqenzschaltung nach der Montage des Abschirmgehäuses sehr aufwendig.

Eine mechanische und elektrisch leitende Verbindung zwischen Abschirmgehäuse und Leiterplatte kann auch durch eine Weichlötung erzielt werden. Zu diesem Zweck wird ein Lotdepot aufgeschmolzen oder Lot aus einer Minilötquelle bzw. über einen aufschmelzenden Lotdraht zugeführt. Die Erwärmung des Abschirmghäuses und der Leiterplatte über den Schmelzpunkt des Lotes hinaus bewirkt jedoch das erneute Aufschmelzen der Lötverbindung der Bauteile zumindest im randnahen Bereich und verursacht eine unzulässige Veränderung dieser Lötstellen oder sogar eine Dejustierung der Bauteile. Auch hierbei ist eine Reparatur auf der Leiterplatte nach der Montage des Abschirmgehäuses relativ aufwendig, da die Lötverbindung wieder aufgeschmolzen werden muß. Dies kann im Inneren des Gehäuses zur Bildung von Lötperlen führen.

Die geringe Steifigkeit flacher Gehäuse erfordert außerdem eine Vielzahl von Schraubverbindungen, um eine aureichende Flächenpressung zu erzielen. Ferner wird die mechanische Vorspannung der Schraubverbindungen durch das Fließen des Kunststoffes reduziert, wenn zwecks Gewichtseinsparung metallisierte Kunststoffteile verwendet werden. Sofern das Abschirmgehäuse andererseits aus einem Zinkdruckgußteil hergestellt wird, erhöht sich das Gewicht, was insbesondere bei mobilen Geräten unerwünscht ist.

Eine gattungsgemäße Ausbildung ist nach der US 4 890 199 bekannt geworden. Hierbei wird ein Klemmprofil über eine Verbindungsfläche mit einer Leiterplatte verbunden. Dieses ist relativ aufwendig, da die Positionierung über gesonderte Hilfsmittel erfolgen muß sowie gegebenenfalls eine getrennte Lötung erforderlich ist.

Der Erfindung liegt somit die Aufgabe zugrunde, ein Befestigungsmittel für Abschirmgehäuse von elektrischen Leiterplatten zu schaffen, das bei einfacher Anwendbarkeit eine sichere mechanische und elektrische Verbindung des Abschirmgehäuses mit der Leiterplatte und dem Massepotential der Schaltung gewährleistet.

Gelöst wird diese Aufgabe mit einem Befestigungsmittel der eingangs genannten Art, dadurch, daß das Klemmprofil mindestens einen Zentrierzapfen aufweist, der in eine Bohrung der Leiterplatte greift.

Ein besonderer Vorteil dieser Lösung besteht darin, daß das Abschirmgehäuse in einfacher Weise abnehmbar ist, um an der Schaltung z. B. Reparaturarbeiten vorzunehmen.

Das erfindungsgemäße Befestigungsmittel ist ferner insbesondere für mobile Telekommunikationsgeräte geeignet, da es nicht nur eine ausreichende Abschirmwirkung des Abschirmgehäuses gewährleistet, sondern auch geringes Gewicht und einen nur geringen Platzbedarf hat.

Schließlich erlaubt die einfache Demontage des Abschirmgehäuses ein kostengünstiges Recycling der gesamten Flachbaugruppe.

Die Unteransprüche haben vorteilhafte Weiterbildungen der Erfindung zum Inhalt.

Das Klemmprofil hat insbesondere eine Länge, die im wesentlichen der Kantenlänge einer Abschirmgehäusewand entspricht. Dadurch können auch großflächige Abschirmgehäuse sicher auf der Leiterplatte befestigt werden.

Das Klemmprofil ist ferner vorzugsweise U-förmig und weist einen ersten und einen zweiten Schenkel auf, die über eine Profilbasis miteinander verbunden sind.

Weiterhin weisen die freien Enden der Schenkel jeweils zueinander gerichtete Klemmspitzen auf, die einen Abstand voneinander haben, der etwa 60 % der Wanddicke eines Abschirmgehäuses beträgt.

Für einen Kompromis zur Kostenreduzierung und für ausreichende Kontakttierung sind auch gerundete Profile möglich.

Zu Erleichterung der Montage eines Abschirmgehäuses ist an den freien Enden der Schenkel jeweils eine Einlaufschräge für eine Gehäusewand vorgesehen.

Die Schenkel haben vorzugsweise eine konkave Innenfläche, die einen stark gerundeten Übergang zur Profilbasis bildet. Dadurch ist einerseits die durch Biegung hervorgerufene Materialbeanspruchung an allen Stellen des Profils gleich hoch, andererseits wird die Kerbwirkung durch die Einspannung einer Gehäusewand reduziert.

An dem Klemmprofil sind mindestens zwei Zentrierzapfen vorgesehen, die entlang des Klemmprofils asymmetrisch angeordnet sind. Dadurch können die Befestigungselemente unmittelbar gegenüberliegend auf beiden Seiten einer Leiterplatte montiert werden. Ferner können die Befestigungsmittel zusammen mit den elektrischen Bauelementen in einem Arbeitsgang auf die Leiterplatte aufgelötet werden.

Ein erfindungsgemäßes Verfahren zur Herstellung eines der genannten Befestigungsmittel zeichnet sich insbesondere dadurch aus, daß ein U-förmiges Klemmprofil als Halbzeug durch spanlose Verformung mittels Ziehen durch Ziehmatrizen erzeugt wird und die Zentrierzapfen durch einen kombinierten Stanz-Biegevorgang aus dem Profil nach unten herausgeformt werden.

Weitere Einzelheiten, Merkmale und Vorteile der Erfindung ergeben sich aus der nachfolgenden Beschreibung einer bevorzugten Ausführungsform anhand der Zeichnung. Es zeigen:
- Fig. 1a, 1b: eine Leiterplatte mit Elektronikbaugruppe und Abschirmgehäuse in Draufsicht bzw. im Querschnitt mit Option einer Trennwand,
- Fig. 2a, 2b, 2c: eine Seitenansicht, eine Draufsicht bzw. eine Stirnansicht eines erfindungsgemäßen Befestigungsmittels,
- Fig. 3a, 3b: einen vergrößerten Querschnitt bzw. eine Teil-Seitenansicht des Befestigungsmittels,
- Fig. 3c: einen Querschnitt bei rundem Profil,
- Fig. 4: einen Teilquerschnitt durch die Leiterplatte mit angesetztem Abschirmgehäuse,
- Fig. 4a: einen Querschnitt bei rundem Profil mit einem Gehäuse ohne Falz
- Fig. 5: einen Teilquerschnitt durch die Leiterplatte mit montiertem Abschirmgehäuse,
- Fig. 6: einen Programmablaufplan der Fertigung von Elektronikbaugruppen,
- Fig. 7: einen Querschnitt durch eine Leiterplatte mit Elektronikbaugruppe und Abschirmgehäuse gemäß dem Stand der Technik **und**
- Fig. 8a, 8b: einen Querschnitt durch eine Leiterplatte mit Elektronikbaugruppe und Abschirmgehäuse bzw. eine Ausschnittvergrößerung einer weiteren Ausführung gemäß dem Stand der Technik.

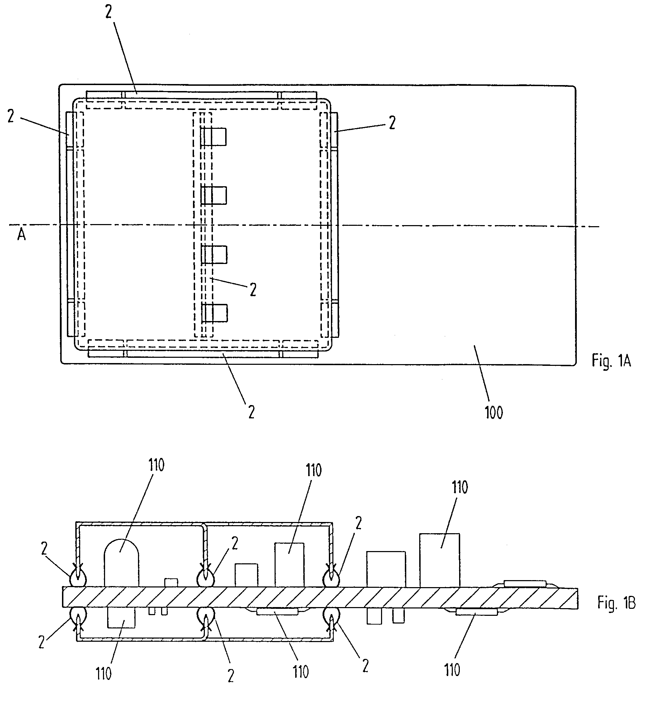

Figur 1a zeigt eine Draufsicht auf eine elektrische Leiterplatte 100 mit einer HF-Schaltung und einer Digitalschaltung. Die HF-Schaltung ist von einem Abschirmgehäuse 1 umgeben. Das Abschirmgehäuse 1 ist entlang seiner vier Seitenwände mit erfindungsgemäßen Befestigungsmitteln 2 an der Leiterplatte 100 befestigt.

Figur 1b zeigt einen Querschnitt entlang der Linie A-A in Figur 1a. Die elektrische Leiterplatte 100 trägt elektronische Bauelemente 110 auf beiden Seiten, so daß für jede Seite jeweils ein Abschirmgehäuse 1 vorgesehen ist. Wie in dieser Figur zu erkennen ist, ermöglichen die erfindungsgemäßen Befestigungsmittel 2 eine sehr flache Ausführung der Abschirmgehäuse 1, die nur durch die Höhe der elektrischen oder elektronischen Bauelemente 110 bestimmt wird.

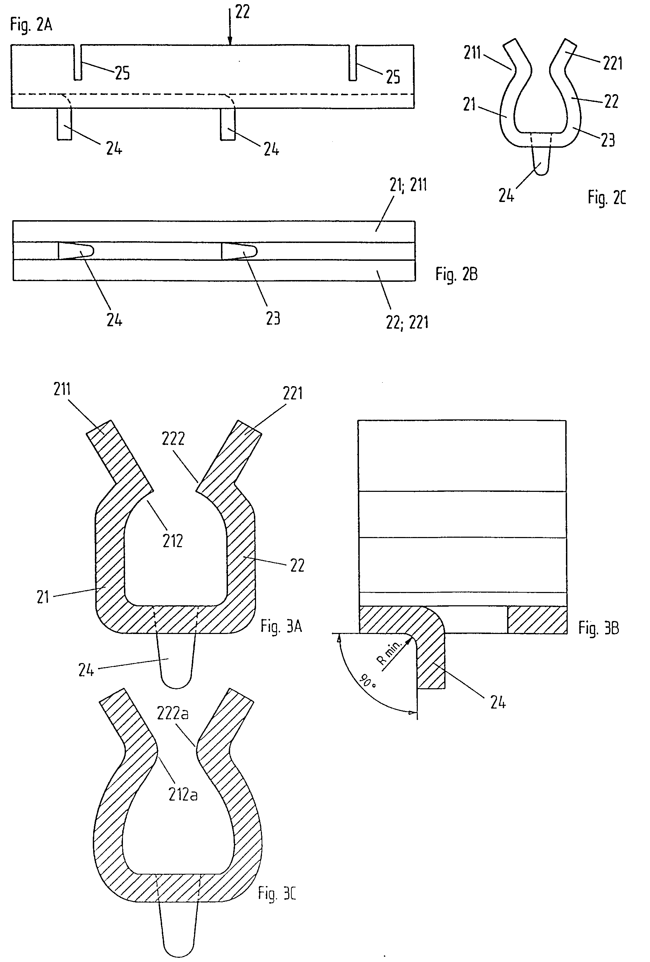

Die Figuren 2a bis 2c zeigen ein erfindungsgemäßes Befestigungsmittel 2 in verschiedenen Ansichten. Aus diesen Darstellungen wird deutlich, daß das Befestigungsmittel im wesentlichen aus einem U-förmigen Klemmprofil mit Schenkeln 21 und 22 besteht, die an einer Profilbasis 23 miteinander verbunden sind, wobei an der Profilbasis 23 ferner zwei Zentrierzapfen 24 vorgesehen sind, die in entsprechende Bohrungen in der elektrischen Leiterplatte eingesetzt werden. Je nach Länge des Befestigungsmittels 2 können ein oder mehrere Zentrierzapfen 24 vorgesehen sein, um die Position auf einer Leiterplatte zu gewährleisten.

Wie insbesondere in der vergrößerten Querschnittsdarstellung der Figur 3a zu erkennen ist, sind die Schenkel 21, 22 an ihren oberen Enden mit Einlaufschrägen 211, 221 versehen, die ein Einführen der entsprechenden Abschirmgehäusewand erleichtern.

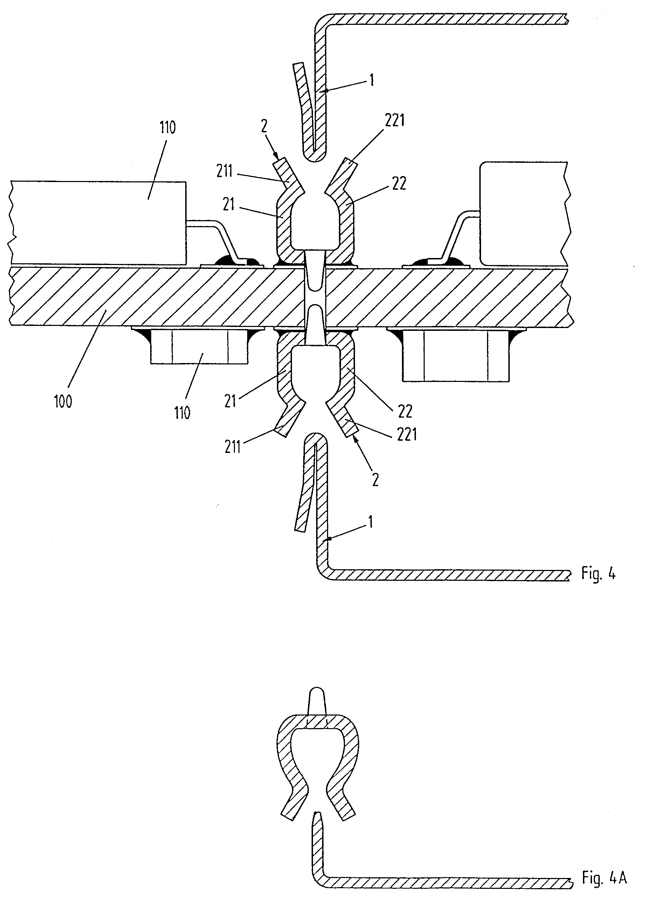

An dem oberen Ende jedes Schenkels befindet sich im Bereich des Übergangs zur Einlaufschräge jeweils eine nach innen gerichtete Profilspitze 212, 222. Die Profilspitzen sind aufeinander zugerichtet und haben einen Abstand voneinander, der etwa 60 % der Wandstärke des Abschirmgehäuses entspricht. Dadurch wird in Verbindung mit der elastischen Verformbarkeit der Schenkel 21, 22 eine sichere Druckkontaktierung des Be festigungsmittels mit der Wand des Abschirmgehäuses gewährleistet. Gerundete Schenkel 212a,222a ohne Spitze sind zur möglichen Kostenreduzierung bei guten Kontakteigenschaften ebenso möglich. Zusätzlich wird das Klemmprofil geschlitzt, Fig. 2a, 25 um mehrere Andruckpunkte zu gewinnen, Fig. 3c, Fig. 4a.

Wie in Figur 3b zu erkennen ist, werden die Zentrierzapfen 24 nach unten aus dem Profil herausgedrückt, und zwar durch einen kombinierten Stanz-Biegevorgang. Die Zentrierzapfen 24 sind gemäß Figur 2a vorzugsweise asymmetrisch entlang der Länge des Klemmprofils angeordnet, um eine gleichsinnige Anordnung der Abschirmgehäuse auf beiden Seiten einer Leiterplatte zu ermöglichen. Die Länge der Zentrierzapfen 24 ist dabei nur geringfügig kleiner, als die Dicke der Leiterplatte.

Figur 4 zeigt einen Teilquerschnitt durch eine Leiterplatte 100 mit Bauelementen 110 sowie Befestigungsmitteln 2, an die jeweils ein Abschirmgehäuse 1 angesetzt ist. Aus dieser Darstellung wird insbesondere deutlich, daß die Abschirmgehäuse ohne aufwendige Justierarbeit mit den Befestigungsmitteln auf der Leiterplatte befestigt werden können. Dies wird durch die Einlaufschrägen 211, 221 bewirkt, die eine automatische Zentrierung der Abschirmgehäuse 1 bewirken.

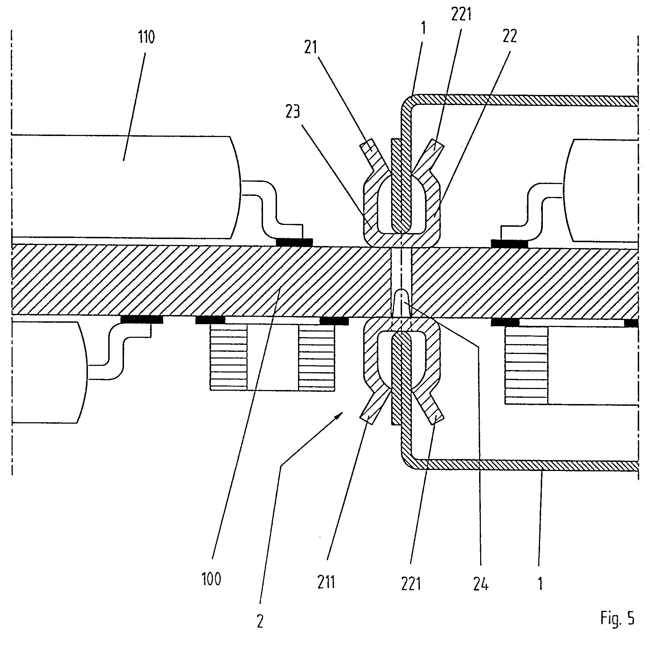

Figur 5 zeigt die Abschirmgehäuse in auf der Leiterplatte befestigtem Zustand. Die Gehäusewand wird so weit in das Befestigungsmittel 2 hineingeschoben, bis sie gegen den Profilbasis 23 stößt. Die konkave Ausformung der Innenflächen der Schenkel 21, 22 bewirkt eine im wesentlichen konstante Materialbeanspruchung aufgrund der elastischen Verformung durch die entsprechend dickere Wand des Abschirmgehäuses. Die dadurch erzeugte Kerbwirkung wird durch die stark gerundeten Übergänge zwischen den Schenkel 21, 22 und der Profilbasis 23 reduziert. Gleichzeitig wird durch die Profilspitzen 212, 222 eine sichere doppelseitige Druckkontaktierung mit der Abschirmgehäusewand erzielt, die für geringe elektrische Übergangswiderstände zwischen Abschirmgehäuse und dem Massepotential der Schaltung sowie eine feste mechanische Arretierung sorgt. Diese doppelseitige Druckkontaktierung mit hoher Flächenpressung über die Profilspitzen sowie der kurze Kraftschluß innerhalb des Klemmprofils sind wesentliche Merkmale der Erfindung. Alternativ dazu einfache "runde" Profilform mit zusätzlichen Schlitzen Fig. 2a, 25 und Fig. 3c, 212a, 222a, Fig. 4a, 300.

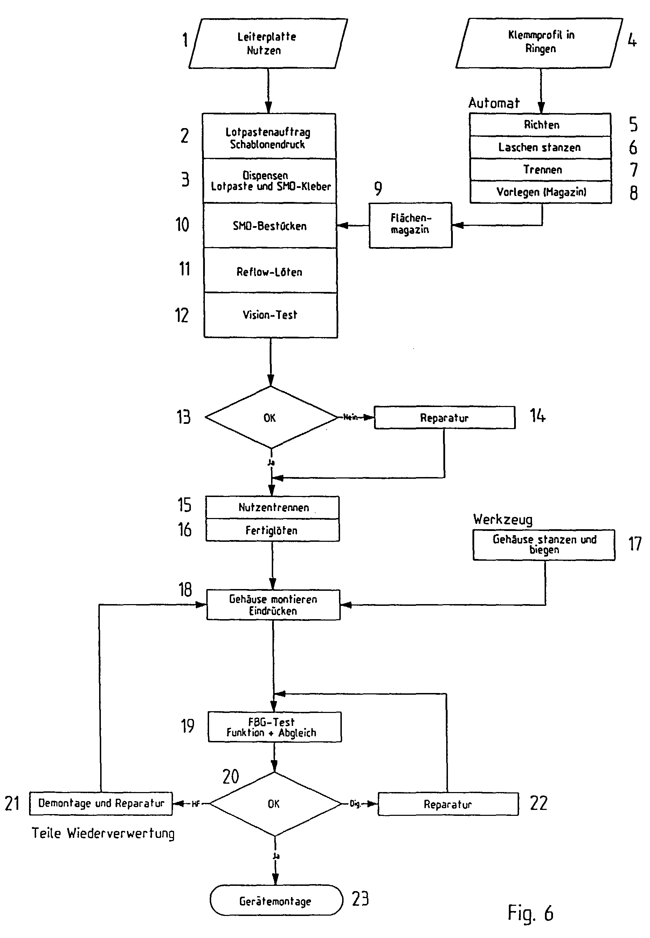

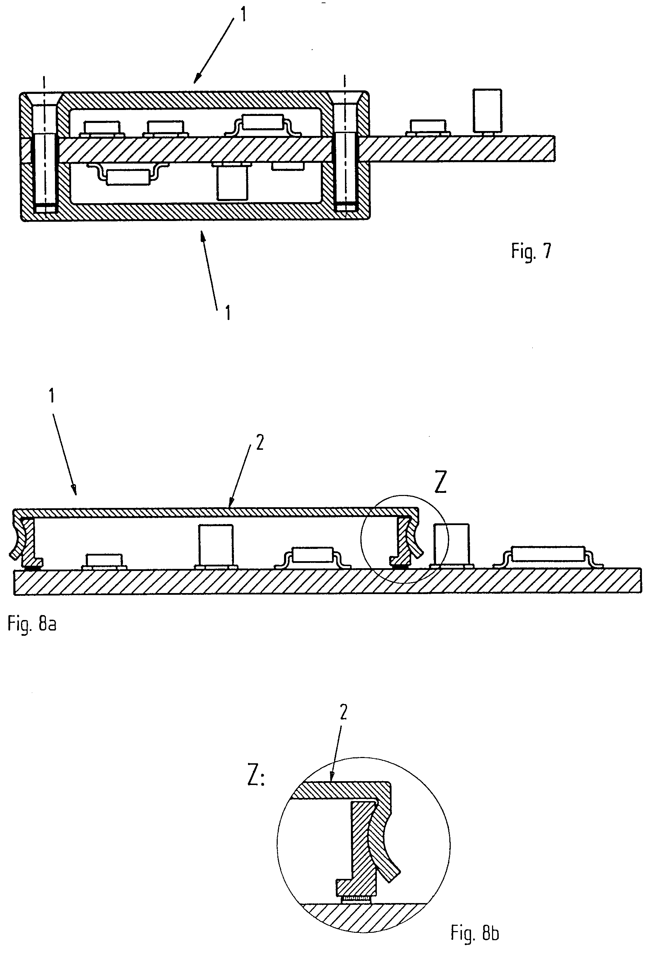

Die Montage der Befestigungmittel 2 auf den Masseleitern der Leiterplatte erfolgt zusammen mit der Montage der elektronischen Bauelemente. Figur 6 zeigt einen Ablaufplan eines entsprechenden Fertigungsverfahrens. Dabei wird gemäß Schritt 1 eine Leiterplatte bereitgestellt und gemäß Schritt 2 über einen Schablonendruck die Lotpaste aufgetragen. Diese wird gemäß Schritt 3 gegebenenfalls zusammen mit einem SMD-Kleber auf der Leiterplatte verteilt.

Parallel dazu werden gemäß Schritt 4 die Befestigungsmittel aus einem vorgefertigen Klemmprofil hergestellt und in einem Automaten gefertigt. Hierzu ist im wesentlichen gemäß Schritt 5 ein Richten, das Einstanzen der Laschen (Schritt 6), das Abtrennen der einzelnen Befestigungsmittel (Schritt 7) sowie ein Vorlegen in ein Magazin gemäß Schritt 8 erforderlich. Über ein Flächenmagazin werden die Befestigungsmittel dann gemäß Schritt 9 mit einem Bestückungsautomaten zusammen mit den elektronischen Bauelementen gemäß Schritt 10 auf die Leiterplatte aufgebracht.

Anschließend erfolgt gemäß Schritt 11 ein Reflow-Löten sowie eine Sichtprüfung (Schritt 12). Sofern sich dabei gemäß der Abfrage in Schritt 13 Fehler ergeben, wird gemäß Schritt 14 eine Reparatur durchgeführt. Gemäß Schritt 15 erfolgt dann das Nutzentrennen sowie gemäß Schritt 16 das Fertiglöten.

Parallel dazu wird gemäß Schritt 17 das Abschirmgehäuse gestanzt und gebogen und in Schritt 18 durch Eindrücken in die Befestigungsmittel auf der Leiterplatte 18 montiert. Anschließend wird gemäß Schritt 19 ein FBG-Test (Funktion und Abgleich) durchgeführt. Wenn sich bei der Abfrage in Schritt 20 im HF-Schaltungsteil ein Fehler ergibt, wird gemäß Schritt 21 das Gehäuse wieder demontiert, eine Reparatur durchgeführt und der Ablauf mit Schritt 18 fortgesetzt. Sofern der digitale Schaltungsteil Fehler aufweist, werden diese gemäß Schritt 22 behoben, worauf Schritt 19 wiederholt wird. Wenn alle Prüfungen ohne Fehler verlaufen, wird die Fertigung mit der Gerätemontage gemäß Schritt 23 abgeschlossen.

Außer der Bereitstellung von Klemmprofilen als Einzelteil im Rohzustand im Arbeitsbereich des Bestückungsautomaten sind keine zusätzlichen Fertigungsschritte erforderlich. Die Bereitstellung erfolgt in wiederverwendbaren Flächenmagazinen mit reproduzierbarer Position und Lage der Klemmprofilteile.

Das Halbzeug des Klemmprofilteils ist in diesem Fall aus einem gut weichlötbaren Nichteisenmaterial durch Ziehen mittels Ziehmatrizen hergestellt. Das Halbzeug wird vorzugsweise in Ringen geliefert. Die starke Kaltverformung beim Ziehvorgang gewährleistet eine hohe Festigkeit der Klemmwirkung sowie eine große Härte für die spanlose Formgebung der zwei Zentrierzapfen durch einen kombinierten Stanz-Biegevorgang sowie das spanlose Trennen ohne wesentliche Deformationen des Profilquerschnitts im Bereich der Trennstellen. Für Fertigungslinien mit großem Durchsatz ist anstelle von Flächenmagazinen mit eingeschränkter Kapazität (etwa 250 Teile pro Magazin) die Zuordnung eines einfachen Automaten zur Herstellung der Klemmprofile direkt vom Ring des Halbzeugs im Bereich des Bestückungsautomaten vorzuziehen.

Die Klemmprofile liegen somit direkt im Zugriff des Bestückungsautomaten. Durch die Verwendung von Flächenmagazinen entfällt ein personalintensives Be- und Entladen, da der Vorrat eines Ringes für mehr als 1000 Elektronikbaugruppen ausreicht, wenn 8 Klemmprofile pro Elektronikbaugruppe eingesetzt werden.

Wenn Abschirmgehäuse mit gleicher Kantenlänge verwendet werden, haben auch alle Befestigungsmittel die gleiche Länge. Den Befestigungsmitteln können jedoch auch andere Formen und beliebige Längen gegeben werden. Die Bohrungen werden in die Leiterplatte in einem Fertigungsschritt mit hoher Lagegenauigkeit eingebracht. Alternativ zu einer Weichlötung können die Befestigungsmittel auch mit einem elektrisch leitenden Kleber auf den Masseleitern der Leiterplatte befestigt werden.

Das Abschirmgehäuse wird vorzugsweise aus Feinblech oder metallisiertem Kunststoff hergestellt. Im Bereich der an den Profilspitzen anliegenden Seitenwände sind diese vorzugsweise dicker als der Abstand der Klemmspitzen ausgelegt, um eine ausreichende Druckkraft durch die elastische Biegung der Profilschenkel 21, 22 zu erreichen. Die Abstimmung des Abstandes der Profilspitzen 212, 222 sowie der Toleranz im Verhältnis zur Dicke der Wand des Abschirmgehäuses erfolgt entsprechend der gewünschten Druckkraft sowie der zulässigen Materialbeanspruchung.

Die Druckkraft der Profilspitzen 212, 222 bewirkt einen Kraftfluß nur innerhalb des Klemmprofils und erzeugt dadurch die notwendige Flächenpressung für die elektrische Kontakgabe zwischen der Wand des Abschirmgehäuses und der Masseleitung der Leiterplatte, sowie die mechanische Positionierung des Abschirmgehäuses relativ zu der Leiterplatte durch die Reibungskraft. Die Reibungskraft beträgt dabei ein Vielfaches der Masse des Abschirmgehäuses und hält dieses auch bei einer Stoßbelastung mit zulässigen Beschleunigungswerten in seiner korrekten Position.

Das Abschirmgehäuse kann entweder als dickwandiges Blech- oder metallisiertes Kunststoffgehäuse oder als dünnwandiges Blechgehäuse mit gefalztem Rand ausgelegt sein. Neben dem geringen Gewicht und der einfachen Herstellung aus bereits oberfächenbehandeltem Feinblech ist die Federung des Falzes als zusätzlicher Toleranzausgleich von Vorteil.

Die Montage des Abschirmgehäuses ist aufgrund der einachsigen Fügerichtung sowie der Begrenzung der Fügebewegung einfach zu gestalten und zu automatisieren. Ebenso einfach ist die Demontage z. B. mit Vakuumsaugern, wobei die Abschirmgehäuse nicht beschädigt und sofort wiederverwendet werden können.

Figur 7 zeigt schematisch ein Abschirmgehäuse mit verschaubtem Deckel. Hierbei liegt jeweils ein Deckel auf jeder Leiterplattenseite, wobei diese Deckel zwecks Verschraubung symmetrisch sein müssen. Die Abschirmwirkung wird bei einer eventuellen Welligkeit der Massebahn auf der Leiterplatte, die insbesondere bei Verwendung von Basismaterialien aus organischen Werkstoffen mit Gewebelaminaten auftreten kann, eingeschränkt. Die Kettfäden des Gewebes bewirken nämlich eine Restwelligkeit der Masseflächen von 5 bis 8 µm, so daß zwischen Gehäuse und Leiterplatte ein Spalt entsteht.

Als weiters Beispiel ist in Figur 8a eine Elektronikbaugruppe im Querschnitt und in Figur 8b eine Ausschnittsvergrößerung (Einzelteil Z), ebenfalls im Querschnitt, dargestellt. Das Abschirmgehäuse 1 ist in diesem Fall aus einem Zinkdruckgußrahmen mit einem dünnwandigen Deckel 2 gebildet. Das hohe Gewicht und die hohen Kosten für den präzisen Druckgußrahmen mit hoher Koplanarität zur Gewährleistung einer sicheren Lötverbindung zur Leiterplatte sowie die nur einfache Kontaktierung des dünnwandigen Deckels mit einem Kraftschluß über das gesamte System, d.h. insbesondere die Leiterplatte, sind jedoch mit Nachteilen behaftet. Eine visuelle Kontrolle und eine gegebenenfalls notwendige Reparatur von Fügestellen ist im randnahen Bereich aufgrund der Höhe des Rahmens kaum möglich.

## Patentansprüche

1. Befestigungsmittel für Abschirmgehäuse von elektrischen Leiterplatten, gebildet durch ein Klemmprofil aus einem elektrisch leitenden Material zum Einklemmen einer Abschirmgehäusewand, dadurch gekennzeichnet, daß das Klemmprofil (2) mindestens einen Zentrierzapfen (24) aufweist, der in eine Bohrung der Leiterplatte (100) greift.

2. Befestigungsmittel nach Anspruch 1, dadurch gekennzeichnet, daß das Klemmprofil (2) mit seinen freien Enden der Schenkel (21, 22) jeweils zueinander gerichtete Klemmspitzen (212, 222) aufweist, die einen Abstand voneinander haben, der etwa 60 % der Wanddicke eines Abschirmgehäuses (1) beträgt.

3. Befestigungsmittel nach Anspruch 1 oder 2, dadurch gekennzeichnet, daß die Schenkel (21, 22) jeweils eine konkave Innenfläche aufweisen, die einen stark gerundeten Übergang zur Profilbasis (23) bildet.

4. Befestigungsmittel nach einem der Ansprüche 1 bis 3, dadurch gekennzeichnet, daß an dem Klemmprofil (2) mindestens zwei Zentrierzapfen (24) vorgesehen sind, die entlang des Klemmprofils asymmetrisch angeordnet sind.

5. Befestigungsmittel nach einem der Ansprüche 1 bis 4, dadurch gekennzeichnet, daß ein geschlitztes Klemmprofil (25) ausgebildet ist.

6. Verfahren zur Herstellung eines Befestigungsmittels nach einem der vorhergehenden Ansprüche, dadurch gekennzeichnet, daß ein U-förmiges Klemmprofil als Halbzeug durch spanlose Verformung mittels Ziehen durch Ziehmatrizen erzeugt wird und die Zentrierzapfen durch einen kombinierten Stanz-Biegevorgang aus dem Profil nach unten herausgeformt werden.

7. Abschirmgehäuse für eine elektrische Leiterplatte, insbesondere zur Verwendung mit einem Befestigungsmittel nach einem der Ansprüche 1 bis 6, dadurch gekennzeichnet, daß es Seitenwände mit umgefalztem Rand aufweist.

8. Abschirmgehäuse nach Anspruch 7, dadurch gekennzeichnet, daß ausgestellte Blechnasen (4) zum Einschieben in Klemmprofile für zusätzliche Kontaktzonen innerhalb der abgeschirmten Baugruppe ausgebildet sind.
